# EUROPEAN PATENT SPECIFICATION

(11) **EP 0 239 267 B1**
(45) Date of publication and mention of the grant of the patent: **18.11.1993**
(21) Application number: 87301892.3
(22) Date of filing: 04.03.1987
(51) Int. Cl.: G06J 1/00

(54) **Integrators**
Integratoren
Intégrateurs

(30) Priority: 24.03.1986 US 843369
(43) Date of publication of application: 30.09.1987
(73) Proprietor: INTERNATIONAL CONTROL AUTOMATION FINANCE S.A., Ville de Luxembourg (LU)
(72) Inventor: Wroblewski, David Joseph, Willoughby Ohio 44094 (US); Robertson, John Walter, Jr., Chesterland Ohio 44026 (US)
(74) Representative: Cotter, Ivan John

(56) References cited:
- US-A- 3 169 185
- US-A- 3 710 376
- US-A- 4 380 757
- US-A- 4 409 660

## Description

This invention relates to integrators for integrating linear voltages, for example linear voltages which correspond directly to a mechanical movement that in turn designates a particular process parameter such as flow rate.

It is known to employ voltage-to-frequency conversion and totalisation techniques in integrators. A prior integrator, known as the Class Y integrator, supplied by Bailey Controls Company (a division of The Babcock & Wilcox Company), Wickliffe, Ohio, USA, consists of mechanical gears and pivot arms and uses no electronics. The Bailey Class Y mechanical integrator suffers from various problems such as poor reliability, poor versatility, large parts inventory due to the fact that many versions of the integrator have been provided over several years, mechanical wear resulting in inaccuracy, specialised labour required for assembly, and specialised labour required for calibration.

One example of a known transducer which can be used to output a linear voltage signal is the Type WM Recorder supplied by Bailey Controls Company. This recorder includes a pen and pointer which designate a percentage range from 0 to 100% and can be used to measure fluid flow as a process parameter. An integrator can be mechanically coupled to the pointer to provide a running integration of the flow quantity over time.

US Patent No. US-A-4 380 757 discloses an electronic integrator for integrating a linear voltage signal over time, the integrator comprising:
input means for applying the linear voltage signal;
voltage-to-frequency conversion means for converting the linear voltage signal to an input frequency signal having a frequency proportional to the linear voltage signal;
a binary counter connected to the voltage-to-frequency conversion means for counting pulses of the input frequency signal; and
scaling means.

US Patent No. US-A-4 409 660 discloses an electronic integrator in which an input 4 to 20 mA current signal is passed through a resistor to develop a voltage signal. The voltage signal is passed via a virtual ground scanning junction to a voltage-to-frequency conversion means. A pulse signal outputted by the voltage-to-frequency conversion means is passed via an adjustable binary scaling circuit to a counter.

According to the present invention there is provided an electronic integrator for integrating a linear voltage signal over time, the integrator comprising:
input means for applying the linear voltage signal;
voltage-to-frequency conversion means for converting the linear voltage signal to an input frequency signal having a frequency proportional to the linear voltage signal;
a binary counter connected to the voltage-to-frequency conversion means for counting pulses of the input frequency signal; and
scaling means;
characterised in that:
the binary counter is operative to generate an operating frequency signal and a calibrating frequency signal having a frequency which is high relative to that of the operating frequency signal;
binary rate multiplying means is connected to the binary counter for receiving the operating frequency signal and for generating a counting rate signal which has pulses that are at a scaled proportion of the operating frequency signal, the binary rate multiplying means having said scaling means for changing the proportion;
a pulse counter is provided for counting pulses of the counting rate signal and for counting pulses of the calibrating frequency signal; and
switch means is provided having a first input connected to the binary counter for receiving the calibrating frequency signal, a second input connected to the binary rate multiplying means for receiving the counting rate signal, and an output connected to the pulse counter, the switch means being selectively switchable between a calibration position connecting said first input to the pulse counter for incrementing the pulse counter rapidly, and an operating position connecting said second input to the pulse counter for incrementing the pulse counter more slowly and at a rate proportional to the linear voltage signal.

The binary rate multiplying means preferably comprises a plurality of binary rate multipliers which are connected in series, each multiplier being provided with a binary coded digital switch for setting a scaling factor in each multiplier.

A preferred integrator embodying the present invention and described hereinbelow is particularly suited to replace the Bailey Class Y mechanical integrator and can be used, for example, with the Bailey Type WM 55 Recorder. However, the present invention is in no way limited to this specific application. The present invention can be used in any situation requiring totalisation (integration) of a rate signal which is linearly related to a mechanical angular rotation. In addition, integrators embodying the invention can be used for integration of any linear voltage signal.

The preferred embodiment of the present invention described hereinbelow avoids problems of the prior mechanical integrator in that it has high reliability and versatility, suffers from virtually no mechanical wear and requires only relatively unskilled personnel for assembly and calibration. The preferred integrator can be used for an immediate conversion of a mechanical signal to an electrical signal, resulting in high reliability that is inherent in electrical signal processing. Adjustable scaling allows one unit to replace most previous integrators. Minimised mechanical parts results in an extended life expectancy. Minimal skill and equipment is necessary for field calibration and use of the preferred integrator results overall in a significant cost reduction.

The preferred electronic or electromechanical integrator is simple in design, rugged in construction and economical to manufacture, while at the same time being easily calibrated and accurate.

The invention will now be further described, by way of illustrative and non-limiting example, with reference to the accompanying drawings, in which:
Figure 1 is a schematic circuit diagram of an electronic integrator embodying the present invention; and
Figure 2 is a plan view of the layout of components of the circuit shown in Figure 1, showing the physical appearance of the electronic integrator.

The drawings show a preferred embodiment of the invention which comprises an electronic integrator which can be mechanically linked to a movable arm or linkage or other member of a transducer, movement of the arm or linkage or other member being proportional to a process parameter to be measured. The electronic integrator can, for example be connected to a moving pointer of the Bailey Controls Company Type WM 55 Recorder mentioned above. Such recorders can be used for measuring flow rate and the electronic integrator can read the total flow over time and thus integrate the flow signal.

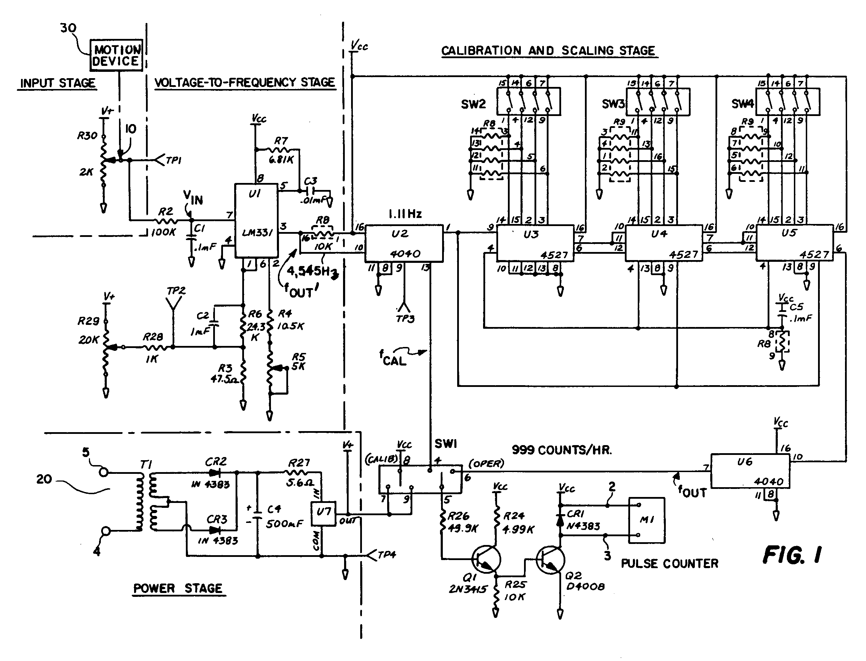

A power supply for the circuit of Figure 1, comprises a POWER STAGE providing a single +12V dc supply V+ derived from a 117V ac input 20 applied to a transformer T1 at terminals 4 and 5. The ac power is rectified by diodes CR2 and CR3 and then filtered and regulated by a capacitor C4 and a resistor R27, and an integrated circuit U7, respectively. This provides all of the power needed for the circuit or unit.

An INPUT STAGE of the integrator comprises a potentiometer R30 which has a shaft thereof, and an lever 10 on the shaft, mechanically connected to a linear mechanical motion device 30. The potentiometer R30 has two poles thereof connected across positive and negative voltage supply terminals of the circuit (shown as V+ and ground). A wiper arm of the potentiometer R30 provides an input voltage V_{IN} to a VOLTAGE-TO-FREQUENCY (V/F) STAGE which converts voltage to frequency. This allows for mechanical movement of the motion device 30 to be converted directly into an electrical representation of that movement, namely the voltage V_{IN}. The VOLTAGE-TO-FREQUENCY STAGE comprises potentiometers R29 and R5, an LM 331 V/F converter U1, resistors R2, R3, R4, R6, R7, R28, part of a resistor array R8 and capacitors C1, C2 and C3, all connected as shown in Figure 1. The VOLTAGE-TO-FREQUENCY STAGE receives the above-mentioned linear electrical signal (the voltage V_{IN}) and produces a corresponding frequency output f_{OUT'} after proper adjustment of the potentiometers R29 (zero adjustment) and R5 (span adjustment). The zero adjustment permits the variations between individual components of the INPUT STAGE to be compensated for.

The zero voltage is the level at which the V/F STAGE produces no output pulses if presented with a voltage less than or equal to that of the zero adjustment. The span adjustment sets the voltage from the potentiometer R30 to 1220 mV ±10 mV. This corresponds to the maximum span voltage of the illustrated integrator, but could be any voltage within the operating conditions of the LM 331 V/F converter U1 which is used in the VOLTAGE-TO-FREQUENCY STAGE. The frequency ouput of the converter U1 is set by adjusting the potentiometor R5 to achieve a period of 440± 20 microseconds at a port (connection) TP3 of a circuit U2 in a following CALIBRATION AND SCALING STAGE. The ouput of the circuit U2 (which circuit is a first stage binary counter) will, as a result of this adjustment, be a frequency of 1.11 Hz at full scale input from the INPUT STAGE.

The frequency of 1.11 Hz is measured at a pin 1 of the circuit U2 and serves for establishing a full scale reading of 1.11 Hz for the scaling section of the integrator. The value of 1.11 Hz is significant in that it will allow the user to input a decimal scaling factor directly by movement of switches SW2, SW3 and SW4. The calibration accuracy and time it takes to calibrate the integrator are both improved by using an output having a higher frequency f_{CAL}, derived by the same circuit U2, for a calibration input.

A pin 13 of the circuit U2 provides the output at the frequency f_{CAL} to an output pulse counter M1 through a switch SW1, an amplifier comprising driver transistors Q1 and Q2, a diode CR1 and resistors R24, R25 and R26, all connected as shown, and terminals 2 and 3. This results in a count rate on the pulse counter M1, which is an electromechanical counter, of 1066 counts per minute. This allows for high accuracy calibration within a comparatively short amount of time compared to normal count rate times of the integrator in service, which may vary from one to 999 counts per hour as set by the scaling factor. The switch SW1 is a double-throw, double-pole, centre OFF switch which either disables power to the CALIBRATION AND SCALING STAGE while input V/F adjustments are being made, or is used to put the integrator in operate (OPER) or calibrate (CALIB) positions. The calibrate (calibration) position allows the scaling section to be by-passed and the faster rate ouput at the frequency f_{CAL} from the pin 13 of the circuit U2 to be applied to the output pulse counter M1 as described above. Placing the switch SW1 in the operate (operating) position will allow the counter M1 to receive pulses from the scaling section of the integrator. This section allows an easy method of scaling an input to read appropriately on the counter M1 of the integrator.

Rather than a complex set of changeable cams, as employed in the prior mechanical integrator, the present integrator uses binary coded decimal (BCD) switches, namely the switches SW2, SW3 and SW4, to directly input the scaling factor. Each of the switches SW2, SW3 and SW4 is connected to a circuit U3, U4 and U5, respectively, the junctions between respective switch elements of each switch and the associated circuit being connected to ground via respective parts of the resistor array R8 and of a resistor array R9 in the manner shown in Figure 1. The circuits U3, U4 and U5 are connected in series. Each of the circuits U3, U4 and U5 is a 4527 binary rate multiplier.

Entry of a number by the user by means of the switches SW2, SW3 and SW4, in such a manner that the setting of the switch SW2 represents hundreds of units, the setting of the switch SW3 represents tens of units and the setting of the switch SW4 represents units, provides for a scale selection between one and 999. This is to represent the maximum number of units per hour of the integrator for a full scale input. The switches SW2, SW3 and SW4 allow the user to enter a decimal number, and the number is converted by the switches to a BCD format for the binary rate multipliers U3, U4 and U5. The binary rate multipliers U3, U4 and U5 are arranged so that the output of the circuit U2 (as calibrated above) is applied as an input to the multiplier U3. Then, an output of the multiplier U3 is presented to the multiplier U4 in proportion to the setting of the switch SW2. An output of the multiplier U3 goes into the multiplier U4 and is proportionately scaled by the setting of the switch SW3. Lastly, the switch SW4 scales the output from the multiplier U4 as it is counted through the multiplier U5. The result is a scaled output of a frequency which is finally divided by four by a binary counter U6 before being presented to the pulse counter M1 through the switch SW1 in its operate (OPER) position.

Pin 4 of each of the multipliers U3, U4 and U5 is connected to the junction of a network comprising a capacitor C5 and part of the resistor array R8.

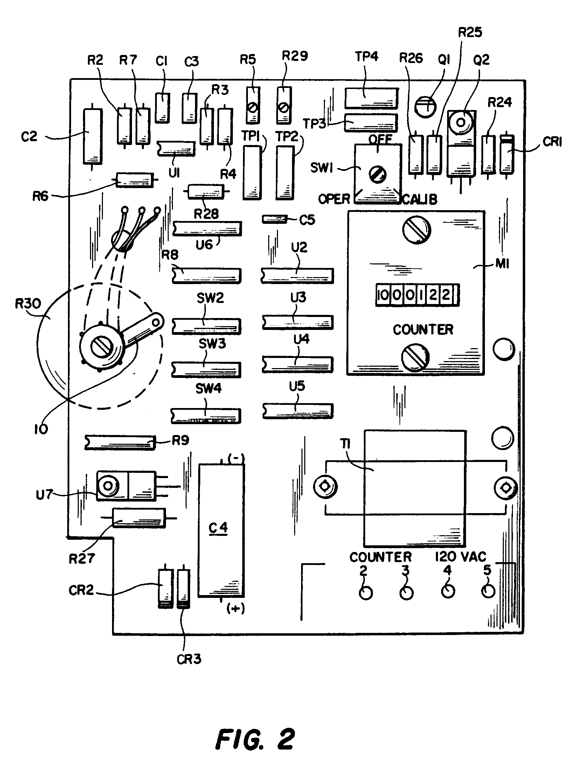

As shown in Figure 2, the counter M1 has a numeric display for visually displaying a number corresponding to the integrated linear voltage signal V_{IN}. Figure 2 also shows the shaft and arm 10 of the potentiometer R30 which can be mechanically linked to the movable member of a transducer such as the pointer of the flow recorder mentioned above. Figure 2 also shows the relative positions of the various elements shown in the circuit of Figure 1.

A particularly important feature of the present integrator is the CALIBRATION AND SCALING STAGE shown in Figure 1. The INPUT STAGE may provide any transduced signal with a linear voltage output and is not limited to a potentiometer per se. The VOLTAGE-TO-FREQUENCY STAGE is conventional and can be replaced by an equivalent circuit capable of converting a linear voltage into a frequency signal with a frequency proportional to the linear voltage. By using the calibration and scaling circuitry of the present integrator, all analog parameters except for the input signal remains static after initial calibration. This means that the output (counting rate) signal f_{OUT} at full scale remains constant regardless of the scale selection effected by using the switches SW2, SW3 and SW4. Any calibration method which deviates f_{OUT} can be shown to introduce analog error beyond that of the present circuit.

Because the counting rate signal f_{OUT} at full scale is static, it is possible to optimise the counting rate signal with respect to accuracy, linearity and calibration criteria.

Digital scaling results in an overall accuracy which is independent of scale, and the ability to change scales without the need for recalibration.

The full scale frequency of the integrator may be calibrated to within 0.1% of full scale using only a time reference with an accuracy and resolution typical of a common electronic wristwatch including a quartz timer with 0.1 second resolution or better. This last advantage is achieved by making the counting rate signal f_{OUT} significantly larger than a typical calibration interval (e.g. perhaps 1 to 5 minutes). The overriding source of error thus becomes the uncertainty in the interval itself.

All of the advantages set forth above are achieved through the use of the circuitry shown in Figure 1. The double-throw switch SW1 is used for calibration. This makes the design very cost efficient, yet still versatile. The integrator can be calibrated utilising a common wristwatch, which enhances its value for use in field applications. In other words, when the switch SW1 is switched over to its calibrate (CALIB) position, the high frequency signal f_{CAL} is applied to the pulse counter M1, changing the numerical display of the counter rapidly. Calibration is achieved by observing the count of the counter and checking the time it takes to reach that count. Adjustment can be made using the zero set and scale set potentiometers R29 and R5 in the VOLTAGE-TO-FREQUENCY STAGE.

The INPUT STAGE may be any transducer or structure which generates a useful linear voltage signal. Any voltage-to-frequency converter can replace the one shown and the signal f_{OUT} can be optimised for the particular converter used.

The circuits U2 to U6 are digital counters and can be represented in general by the transfer functions:

${\text{f}}_{\text{OUT'}} {\text{= n/m(f}}_{\text{OUT}} \text{)}$

where n and m are integers and m is greater than or equal to n; and

${\text{f}}_{\text{CAL}} {\text{= k(f}}_{\text{OUT}} \text{)}$

where k is an integer and is useful in the case where k is much greater than n/m for the purpose of calibration.

The connection (port) TP3 and further connections TP1, TP2 and TP4 shown in Figure 1 are used during installation of the integrator to help make initial settings for an initial calibration of the integrator to suit a particular transducer. For example, when using the integrator with the Type WM55 Recorder, a voltmeter having an accuracy of 0.1mV is connected to the connections TP1 (positive terminal) and TP4 (negative terminal). The INPUT STAGE potentiometer R30 is then turned until a reading of 200mV ± 50mV is reached. This procedure is followed with the calibration switch SW1 in its OFF or neutral position. Power is thus removed from all circuitry except for the input and zero potentiometers R29 and R30. This sets an initial position for the lever 10 which can then be secured to the shaft of the potentiometer R30. The negative voltmeter probe can then be moved from the connection TP4 to the connection TP2. In this position, the potentiometer R29 is rotated until a reading of -3mV ± 1mV is read on the voltmeter.

Inputs of 50% and 100% are then applied artificially by rotating the lever 10 and the voltage measurements are recorded. If the voltage span from 0 to 50% is less than the voltage span from 50 to 100% by more than 10mV, an adjustment must be made in the linkage between the lever arm 10 and the pointer of the recorder (not shown). Similar adjustments are necessary if the span from 0 to 50% is greater than the span from 50 to 100% by more than 10mV.

To calibrate the integrator once the lever arm 10 and the potentiometer R29 have been set as noted above, the switch SW1 is switched to its calibrate position for 15 seconds. Beforehand, the number indicated in the display of the counter M1 is noted. The 15 seconds can be verified by using a quartz watch with a sweeping second hand. After 15 seconds, the switch SW1 is returned to its neutral or OFF position. With the switch SW1 in the calibrate position, the counter operates at high frequency using the signal f_{CAL} from the counter U2.

The count now appearing on the counter M1 is then recorded and subtracted from the previous reading to give the count rate for the 15 second period. If the count rate is less than 133, the span or range potentiometer R5 is rotated clockwise to increase the counting speed. If the rate is more than 133, the potentiometer R5 is turned anticlockwise to decrease the speed.

For a course adjustment, the foregoing steps are repeated until a 15 second count of 133 ± 1 is achieved.

For a finer adjustment, a longer period can be taken. For example, a count of 533 ± 1 should result if the switch SW1 is placed in the calibrate position for 60 seconds.

As noted above, the scale is selected by manipulating the switches SW2, SW3 and SW4, each being in the BCD format so that each can be switched for providing a number from 0 to 9, and thus from 100 to 900 for the muliplier U3, from 10 to 90 for the multiplier U4 and from 1 to 9 for the multiplier U5.

## Claims

1. An electronic integrator for integrating a linear voltage signal over time, the integrator comprising:
input means (30) for applying the linear voltage signal (V_{IN});
voltage-to-frequency conversion means (U1) for converting the linear voltage signal (V_{IN}) to an input frequency signal having a frequency (f_{OUT'}) proportional to the linear voltage signal (V_{IN});
a binary counter (U2) connected to the voltage-to-frequency conversion means (U1) for counting pulses of the input frequency signal; and
scaling means;
characterised in that:
the binary counter (U2) is operative to generate an operating frequency signal and a calibrating frequency signal having a frequency (f_{CAL}) which is high relative to that of the operating frequency signal;
binary rate multiplying means (U3-U6, SW2-SW4) is connected to the binary counter (U2) for receiving the operating frequency signal and for generating a counting rate signal which has pulses that are at a scaled proportion of the operating frequency signal, the binary rate multiplying means having said scaling means (SW2-SW4) for changing said proportion;
a pulse counter (M1) is provided for counting pulses of the counting rate signal and for counting pulses of the calibrating frequency signal; and
switch means (SW1) is provided having a first input connected to the binary counter (U2) for receiving the calibrating frequency signal, a second input connected to the binary rate multiplying means (U3-U6, SW2-SW4) for receiving the counting rate signal, and an output connected to the pulse counter (M1), the switch means (SW1) being selectively switchable between a calibration position connecting said first input to the pulse counter (M1) for incrementing the pulse counter rapidly, and an operating position connecting said second input to the pulse counter (M1) for incrementing the pulse counter more slowly and at a rate proportional to the linear voltage signal (V_{IN}).

2. An integrator according to claim 1, wherein the pulse counter (M1) has a numeric display for displaying the count of the pulse counter, the numeric display changing more rapidly when the switch means (SW1) is in its calibration position than when the switch means is in its operating position.

3. An integrator according to claim 1 and claim 2, wherein the switch means (SW1) comprises a double-throw switch having a neutral off position in which neither of said first and second inputs is connected to said output.

4. An integrator according to claim 3, wherein the double-throw switch (SW1) comprises a double-pole double-throw switch having additional inputs and an additional output, a power supply (T1 etc.) is connected to said additional inputs, said additional output is connected to the pulse counter (M1) for powering the pulse counter, and the switch (SW1) is so arranged that, in its off position, it will supply no power to the pulse counter (M1).

5. An integrator according to claim 4, wherein the binary rate multiplying means (U3-U6, SW2-SW4) comprises a plurality of binary rate multipliers (U3-U5) connected in series, a first one (U3) of the multipliers (U3-U5) in the series being connected to the digital counter (U2) for receiving the operating frequency signal, a binary counter (U6) connected between an output of a last one (U5) of the multipliers (U3-U5) in the series and said second input of the switch means (SW1), and a binary coded digital switch (SW2-SW4) connected to each of the multipliers (U3-U5) for setting a value in each multiplier to scale the counting rate signal.

6. An integrator according to claim 5, wherein the pulse counter (M1) includes amplifying means (Q1, Q2) connected to said output of the switch means (SW1) for amplifying the counting rate signal and the calibrating frequency signal, the amplifying means having a power input connected to said additional output of the double-pole double-throw switch (SW1).

7. An integrator according to any one of claims 1 to 4, wherein the binary rate multiplying means (U3-U6, SW2-SW4) comprises a plurality of binary rate multipliers (U3-U5) connected in series, a first one (U3) of the multipliers (U3-U5) in the series being connected to the digital counter (U2) for receiving the operating frequency signal, a binary counter (U6) connected between an output of a last one (U5) of the multipliers (U3-U5) in the series and said second input of the switch means (SW1), and a binary digital switch (SW2-SW4) connected to each of the multipliers (U3-U5) for setting a value in each multiplier to scale the counting rate signal.

## Patentansprüche

1. Elektronischer Integrator zum Integrieren eines linearen Spannungssignales über der Zeit, wobei der Integrator aufweist:
eine Eingabeeinrichtung (30), um das lineare Spannungssignal (V_{IN}) anzulegen,
eine Spannungs-/Frequenz-Wandlungseinrichtung (U1) zum Umwandeln des linearen Spannungssignals (V_{IN}) in ein Eingangsfrequenzsignal, welches eine Frequenz (f_{OUT'}) hat, die zu dem linearen Spannungssignal (V_{IN}) proportional ist,
einen Binärzähler (U2), der mit der Spannungs-/Frequenz-Wandlungseinrichtung (U1) verbunden ist, um die Impulse des Eingangsfrequenzsignales zu zählen, und
eine Skaliereinrichtung,
dadurch gekennzeichnet, daß
der Binärzähler (U2) so betreibbar ist, daß er ein Betriebsfrequenzsignal und ein Eichfrequenzsignal erzeugt, welches eine Frequenz (f_{CAL}) hat, die groß ist im Vergleich zu der des Betriebsfrequenzsignales,
eine Binärraten-Multipliziereinrichtung (U3-U6, SW2-SW4) mit dem Binärzähler (U2) verbunden ist, um das Betriebsfrequenzsignal zu empfangen und um ein Zählratensignal zu erzeugen, das in einem skalierten Verhältnis zu dem Betriebsfrequenzsignal steht, wobei die Binärraten-Multipliziereinrichtung die Skaliereinrichtung (SW2-SW4) für das Ändern dieses Verhältnisses hat,
ein Pulszähler (M1) vorgesehen ist für das Zahlen von Impulsen des Zählratensignales und zum Zählen von Impulsen des Eichfrequenzsignals, und
eine Umschalteinrichtung (SW1) vorgesehen ist, die einen ersten Eingang hat, welcher mit dem Binärzähler (U2) verbunden ist, um das Eichfrequenzsignal zu empfangen, während ein zweiter Eingang mit der Binärraten-Multipliziereinrichtung (U3-U6, SW2-SW4) verbunden ist, um das Zählratensignal zu empfangen, und deren Ausgang mit dem Impulszähler (M1) verbunden ist, wobei die Schalteinrichtung (SW1) wahlweise umschaltbar ist zwischen einer Eichstellung, welche den ersten Eingang mit dem Impulszähler (M1) verbindet, um den Impulszähler schnell heraufzusetzen, und einer Betriebsposition, in weicher der zweite Eingang mit dem Impulszähler (M1) verbunden ist, um den Impulszähler langsamer und mit einer Geschwindigkeit ansteigen zu lassen, die proportional zu dem linearen Spannungssignal (V_{IN}) ist.

2. Integrator nach Anspruch 1, wobei der Impulszähler (M1) eine numerische Anzeige für das Anzeigen der Zählung des Impulszählers hat, wobei die numerische Anzeige sich schneller ändert, wenn die Umschalteinrichtung (SW1) sich in ihrer Eichposition befindet, als dann, wenn die Umschalteinrichtung sich in ihrer Betriebsstellung befindet.

3. Integrator nach Anspruch 1 und Anspruch 2, wobei die Umschalteinrichtung (SW1) einen Zweiwegeumschalter aufweist, der eine neutrale Aus-Position hat, in weicher weder der erste noch der zweite Eingang mit dem Ausgang verbunden ist.

4. Integrator nach Anspruch 3, wobei der Zweiwegeumschalter (SW1) einen zweipoligen Zweiwegeumschalter enthält, der zusätzliche Eingänge und einen zusätzlichen Ausgang hat, wobei eine Energieversorgung (T1 etc.) mit den zusätzlichen Eingängen verbunden ist, der zusätzliche Ausgang mit dem Impulszähler (M1) verbunden ist, um den Impulszähler mit Energie zu versorgen, und der Schalter (SW1) so angeordnet ist, daß er in seiner Aus-Position dem Impulszähler (M1) keine Energie zuführt.

5. Integrator nach Anspruch 4, wobei die Binärraten-Multipliziereinrichtung (U3-U6, SW2-SW4) eine Mehrzahl von Binärraten-Multiplizierern (U3-U5) aufweist, die in Reihe geschaltet sind, wobei ein erster (U3) der Multiplizierer (U3-U5) in der Reihe mit dem digitalen Zähler (U2) für den Empfang des Betriebsfrequenzsignales verbunden ist, ein Binärzähler (U6) zwischen einem Ausgang zumindest eines (U5) der Multiplizierer (U3-U5) in die Reihe geschaltet ist und daß der zweite Eingang der Umschalteinrichtung (SW1) sowie ein binär codierter Digitalschalter (SW2-SW4) für jeden der Multiplizierer (U3-U5) angeschlossen ist, um in jedem Multiplizierer einen Wert so einzustellen, daß er mit der Skala des Zählratensignales im Maßstab zusammenpaßt, bzw. das Zählratensignal skaliert ist.

6. Integrator nach Anspruch 5, wobei der Impulszähler (M1) eine Verstärkungseinrichtung (Q1, Q2) aufweist, welche mit dem Ausgang der Umschalteinrichtung (SW1) verbunden ist, um das Zählratensignal und das Eichfrequenzsignal zu verstärken, wobei die Verstärkungseinrichtung einen Leistungseingang hat, der mit dem zusätzlichen Ausgang des zweipoligen Zweiwegeschalters (SW1) verbunden ist.

7. Integrator nach einem der Ansprüche 1 bis 4, wobei die Binärraten-Multipliziereinrichtung (U3-U6, SW2-SW4) eine Mehrzahl von Binärraten-Multiplizierern (U3-U5) aufweist, die in Reihe geschaltet sind, wobei ein erster (U3) der Multiplizierer (U3-U5) in die Reihe mit dem Digitalzähler (U2) geschaltet ist, um das Betriebsfrequenzsignal zu empfangen, ein Binärzähler (U6) zwischen einen Ausgang zumindest eines (U5) der Multiplizierer (U3-U5) in der Reihe und den zweiten Eingang der Umschalteinrichtung (SW1) geschaltet ist, und wobei ein binärer Digitalschalter (SW2-SW4) mit jedem der Multiplizierer (U3-U5) verbunden ist, um in jedem Multiplizierer einen Wert so einzustellen, daß er skalenmäßig mit dem Zählratensignal zusammenpaßt bzw. das Zählratensignal skaliert ist.

## Revendications

1. Intégrateur électronique pour intégrer un signal de tension linéaire par rapport au temps, l'intégrateur comprenant :
un moyen d'entrée (30) pour appliquer le signal de tension linéaire (V_{IN}) ;
un moyen de conversion de tension en fréquence (U1) pour convertir le signal de tension linéaire (V_{IN}) en un signal de fréquence d'entrée ayant une fréquence (f_{OUT')} proportionnelle au signal de tension linéaire (V_{IN}) ;
un compteur binaire (U2) connecté au moyen de conversion de tension en fréquence (U1) pour compter les impulsions du signal de fréquence d'entrée ; et,
un moyen de mise à l'échelle ;
caractérisé en ce que :
le compteur binaire (U2) sert à produire un signal de fréquence de mise en oeuvre et un signal de fréquence d'étalonnage ayant une fréquence (f_{CAL}) qui est élevée par rapport à celle du signal de fréquence de mise en oeuvre ;
un moyen de multiplication de cadence binaire (U3 à U6, SW2 à SW4) est connecté au compteur binaire (U2) pour recevoir le signal de fréquence de mise en oeuvre et pour produire un signal de cadence de comptage qui a des impulsions qui sont en proportion du signal de fréquence de mise en oeuvre, le moyen de multiplication de cadence binaire comportant ledit moyen de mise à l'échelle (SW2 à SW4) pour modifier ladite proportion ;
un compteur d'impulsions (M1) est prévu pour compter les impulsions du signal de cadence de comptage et pour compter les impulsions du signal de fréquence d'étalonnage ; et,
un moyen de commutation (SW1) est prévu, ayant une première entrée reliée au compteur binaire (U2) pour recevoir le signal de fréquence d'étalonnage, une seconde entrée reliée au moyen de multiplication de cadence binaire (U3 à U6, SW2 à SW4) pour recevoir le signal de cadence de comptage, et une sortie reliée au compteur d'impulsions (M1), le moyen de commutation (SW1) étant commutable entre une position d'étalonnage, reliant ladite première entrée au compteur d'impulsions (M1), pour incrémenter rapidement le compteur d'impulsions, et une position de mise en oeuvre, reliant ladite seconde entrée au compteur d' impulsions (M1), pour incrémenter le compteur d'impulsions plus lentement et à une cadence proportionnelle au signal de tension linéaire (V_{IN}).

2. Intégrateur selon la revendication 1, dans lequel le compteur d'impulsions (M1) possède un affichage numérique pour afficher le comptage du compteur d'impulsions, l'affichage numérique changeant plus rapidement lorsque le moyen commutateur (SW1) est dans sa position d'étalonnage que lorsque le moyen commutateur est dans sa position de mise en oeuvre.

3. Intégrateur selon la revendication 1 ou la revendication 2, dans lequel le moyen commutateur (SW1) comprend un commutateur inverseur ayant une position neutre en l'air dans laquelle ni l'une ni l'autre desdites première et seconde entrées n'est reliée à ladite sortie.

4. Intégrateur selon la revendication 3, dans lequel le commutateur inverseur (SW1) est constitué d'un commutateur à deux contacts inverseurs ayant des entrées supplémentaires et une sortie supplémentaire, dans lequel une alimentation en courant (T1, etc.) est reliée auxdites entrées supplémentaires, dans lequel ladite sortie supplémentaire est reliée au compteur d'impulsions (M1) pour alimenter en énergie le compteur d'impulsions, et dans lequel le commutateur (SW1) est agencé de telle façon que, dans sa position coupée il ne délivre aucun courant au compteur d'impulsions (M1).

5. Intégrateur selon la revendication 4, dans lequel le moyen multiplicateur a cadence binaire (U3 à U6, SW2 à SW4) comprend une pluralité de multiplieurs à cadence binaire (U3 à U5) connectés en série, un premier (U3) des multiplieurs (U3 à U5) en série étant connecté au compteur numérique (U2) pour recevoir le signal de fréquence de mise en oeuvre, un compteur binaire (U6) étant connecté entre une sortie d'au moins l'un (U5) des multiplieurs (U3 à U5) en série et ladite seconde entrée du moyen commutateur (SW1), et un commutateur numérique codé binaire (SW2 à SW4) étant connecté à chacun des multiplieurs (U3 à U5) pour régler une valeur dans chaque multiplieur pour mettre à l'échelle le signal de rapport de comptage.

6. Intégrateur selon la revendication 5, dans lequel le compteur d'impulsions (M1) comprend un moyen amplificateur (Q1, Q2) connecté à ladite sortie du moyen commutateur (SW1) pour amplifier le signal de rapport de comptage et le signal de fréquence d'étalonnage, le moyen amplificateur ayant une entrée de courant connectée à ladite sortie supplémentaire du commutateur à deux contacts inverseurs (SW1).

7. Intégrateur selon l'une quelconque des revendications 1 à 4, dans lequel le moyen multiplicateur a cadence binaire (U3 à U6, SW2 à SW4) comprend une pluralité de multiplieurs à cadence binaire (U3 à U5) connectés en série, un premier (U3) des multiplieurs (U3 à U5) en série étant connecté au compteur numérique (U2) pour recevoir le signal de fréquence de mise en oeuvre, un compteur binaire (U6) étant connecté entre une sortie d'au moins l'un (U5) des multiplieurs (U3 à U5) en série et ladite seconde entrée du moyen commutateur (SW1), et un commutateur numérique binaire (SW2 à SW4) étant connecté à chacun des multiplieurs (U3 à U5) pour régler une valeur dans chaque multiplieur pour mettre à l'échelle le signal de rapport de comptage.
